# EUROPEAN PATENT SPECIFICATION

(11) **EP 2 925 089 B1**
(45) Date of publication and mention of the grant of the patent: **10.01.2018**
(21) Application number: 13856203.8
(22) Date of filing: 07.11.2013
(51) Int. Cl.: H05B 33/02, B32B 15/04, C25D 7/00, H01L 51/42, H01L 51/50, C25D 5/50, C23C 18/16, C23C 18/32, C25D 7/06, H01L 51/00, B32B 17/06, C25D 5/36, C23C 18/18

(54) **SUBSTRATE FOR FLEXIBLE DEVICES AND METHOD FOR PRODUCING SAME**
SUBSTRAT FÜR FLEXIBLE VORRICHTUNGEN UND VERFAHREN ZU DESSEN HERSTELLUNG
SUBSTRAT POUR DISPOSITIFS FLEXIBLES ET MÉTHODE DE PRODUCTION DE CELUI-CI

(30) Priority: 26.11.2012 JP 2012257541
(43) Date of publication of application: 30.09.2015
(73) Proprietor: Toyo Seikan Group Holdings, Ltd., Shinagawa-ku Tokyo 141-8627 (JP); Tokan Material Technology Co., Ltd., Kita-ku Osaka-shi Osaka 531-8526 (JP)
(72) Inventor: NISHIYAMA Shigeyoshi, Tokyo 102-8447 (JP); SHIMOMURA Hiroshi, Osaka-shi Osaka 531-8526 (JP)
(74) Representative: Schrell, Andreas
(86) International application number: PCT/JP2013/080094
(87) International publication number: WO 2014/080765

(56) References cited:
- WO-A1-2012/067146
- JP-A- H 062 104
- JP-A- 2008 243 772
- JP-A- 2012 133 944
- US-A1- 2012 155 093
- XIAOMING YU JIAXIN SUN XIULING ZHU MAN WONG AND HOI SING KWOK ET AL: "P-230: Novel Electrical-Chemically Polished Stainless Steel Anode Organic Light Emission Device with Long Lifetime at High Luminance for Flexible Lighting", SID 2008, 2008 SID INTERNATIONAL SYMPOSIUM, SOCIETY FOR INFORMATION DISPLAY, LOS ANGELES, USA, vol. XXXIX, 18 May 2008 (2008-05-18), pages 2064-2066, XP007016879, ISSN: 0008-966X

## Description

### Technical Field

The present invention relates to a substrate for flexible devices that is used as a substrate for organic EL, for example, organic EL illumination, an organic EL display, or an organic solar battery, and a method for producing the same.

### Background Art

Patent Literature 1 shows the structure of an organic EL (electroluminescence) element that is obtained by sequentially laminating a transparent conductive layer, an organic light emitting medium layer, and a cathode layer on a plastic film base, and laminating a metal foil thereon with an adhesive layer interposed therebetween.

Patent Literature 2 shows the structure of a substrate for flexible devices that is obtained by providing a planarized layer of polyimide resin on a stainless steel base.

Patent Literature 3 shows the structure of a substrate for a flexible solar battery that is obtained by depositing a film of silica glass on a stainless steel base.

Patent Literature 4 discloses a substrate for flexible devices comprising a metal base such as stainless steel and a smooth nickel-plated layer, which renders polishing or smoothing by Spin-On Glass technology unnecessary.

### Citation List

### Patent Literature

Patent Literature 1: JP 2004-171806 A
Patent Literature 2: JP 2011-97007 A
Patent Literature 3: JP 2006-80370 A
Patent Literature 4 : JP 2008-243772 A

### Summary of Invention

### Technical Problem

The film base used in Patent Literature 1 has a low moisture barrier property, and thus has a possibility that deterioration of organic EL elements may be promoted by moisture. Polyimide resin used in Patent Literature 2 has a high water-absorbing property, and thus has a possibility that, when the substrate is used as a substrate for organic EL, deterioration of organic EL elements may be promoted by absorbed moisture. Silica glass used in Patent Literature 3 typically has a smaller coefficient of thermal expansion than iron and stainless steel and thus has a low adhesion property to the stainless steel base. Further, silica glass has a problem in that it is weak against bending work and shocks.

The present invention has been made in view of the foregoing, and it is an object of the present invention to provide a substrate for flexible devices that has a high moisture barrier property and has an insulating layer with a high adhesion property.

### Solution to Problem

A substrate for flexible devices of the present invention that solves the aforementioned problem includes a metal base, a Ni plating layer formed over the surface of the metal base, and a glass layer formed over the surface of the Ni plating layer by forming bismuth-based glass with an electrically insulating property in the form of a layer.

In addition, the method for producing a substrate for flexible devices of the present invention includes a plating step of forming a Ni plating layer over the surface of a metal base and a glass layer forming step of forming a glass layer of bismuth-based glass with an electrically insulating property over the surface of the Ni plating layer.

### Advantageous Effects of Invention

According to the present invention, a Ni plating layer is formed over the surface of a metal base, and a glass layer is formed over the surface of the Ni plating layer. Thus, a lightweight, flexible metal substrate for flexible devices can be obtained that has a high moisture barrier property and has formed bismuth-based glass with a high adhesion property to the metal base. Further, as bismuth-based glass with an electrically insulating property is formed, the substrate also has an excellent insulating property and planarity, and thus can be used as a substrate for organic EL. Other problems, structures, and advantageous effects will become apparent from the following description of embodiments. The present specification contains the descriptions of the specification and/or drawings of the Japanese patent application JP 2012-257541 that serves as a basis for priority claim of the present application.

### Brief Description of Drawings

Fig. 1 is a schematic diagram showing the cross-sectional structure of a substrate for flexible devices of this embodiment.
Fig. 2 is a schematic diagram showing the cross-sectional structure of a substrate for organic EL illumination that uses a substrate for flexible devices of this embodiment.

### Description of Embodiments

Next, embodiments of the present invention will be described in detail with reference to the drawings.

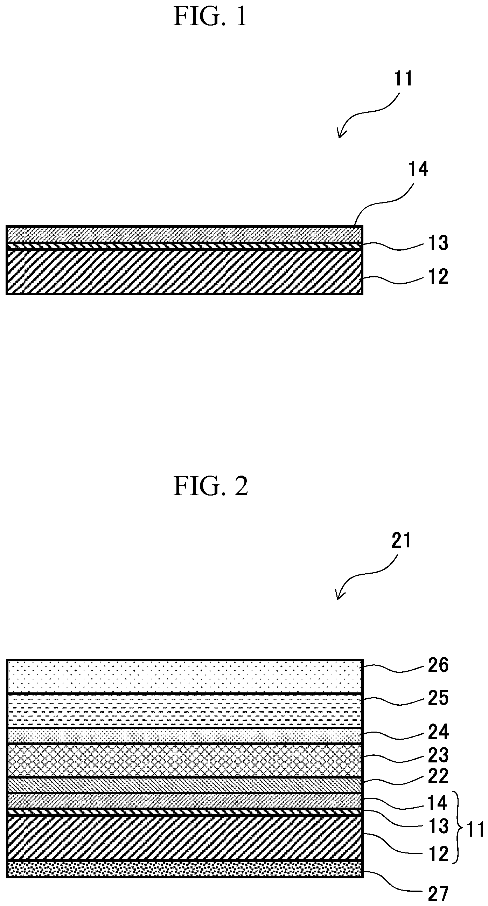

Fig. 1 is a diagram schematically showing the cross-sectional structure of an exemplary substrate for flexible devices in accordance with this embodiment.

A substrate 11 for flexible devices includes a metal base 12, a Ni plating layer 13 formed over the surface of the metal base 12, and a glass layer 14 formed over the surface of the Ni plating layer 13.

The thickness of the metal base 12 is greater than or equal to 25 µm and less than or equal to 200 µm, more preferably, greater than or equal to 50 µm and less than or equal to 150 µm. The thickness of the Ni plating layer 13 is greater than or equal to 0.1 µm and less than or equal to 10 µm, more preferably, greater than or equal to 0.5 µm and less than or equal to 5 µm. The thickness of the glass layer 14 is greater than or equal to 1 µm and less than or equal to 50 µm, more preferably, greater than or equal to 1 µm and less than or equal to 20 µm.

The method for producing the substrate 11 for flexible substrates includes a plating step of forming the Ni plating layer 13 on the surface of the metal base 12 and a glass layer forming step of forming the glass layer 14 on the surface of the Ni plating layer 13.

The metal base 12 is formed of a steel plate, stainless steel, or titanium, for example, that has a coefficient of thermal expansion of greater than or equal to 8 × 10⁻⁶/°C and less than or equal to 14 × 10⁻⁶/°C, more preferably, greater than or equal to 9 × 10⁻⁶/°C and less than or equal to 13 × 10⁻⁶/°C.

The substrate 11 for flexible devices may also have an alloy layer, which is formed by thermal treatment, between the surface of the metal base 12 and the Ni plating layer 13. The thermal treatment is conducted after the Ni plating layer 13 is formed over the metal base 12. The thermal treatment is conducted under the following conditions: a temperature of greater than or equal to 300 °C and less than or equal to 900 °C, more preferably, greater than or equal to 400 °C and less than or equal to 800 °C and a time of less than 10 minutes, more preferably, greater than or equal to 0.1 minute and less than or equal to 3 minutes.

The Ni plating layer may be any layer as long as it is formed by Ni plating. Thus, the Ni plating layer may be formed by any of electroplating or electroless plating. However, electroplating is preferably used from the perspective of continuous productivity. The plating step may differ depending on the base used. For example, when Ni plating is applied onto a steel plate, the Ni plating is applied after the metal base 12 is subjected to alkaline electrolytic degreasing and acid cleaning through sulfuric acid immersion. For a Ni plating bath, a bath that is widely used can be used, such as a Watts bath or a sulfamic acid bath.

The glass layer 14 is formed of electrically insulating bismuth-based glass with a softening point of greater than or equal to 330 °C and less than or equal to 450 °C, more preferably, greater than or equal to 360 °C and less than or equal to 420 °C. The bismuth-based glass preferably contains greater than or equal to 70 wt% Bi₂O₃ as the main component of the glass.

As the temperature at which de-binding is conducted is 330 °C, if glass that softens at a low temperature of around 330 °C is used, cracked gas in the binder will enter the glass, which can generate pinholes. Meanwhile, bismuth-based glass that softens at a temperature lower than 360 °C is likely to be crystallized during the main baking. The surface of the bismuth-based glass that is crystalized will lose smoothness.

If glass with a softening point of greater than 450 °C is used, a high temperature would be needed in the main baking. Thus, it is difficult to deposit a film at a temperature around the heatproof temperature of Ni plating. Meanwhile, if the main baking is conducted at a relatively low temperature, the glass will not melt sufficiently. Thus, the smoothness of the surface will be lost.

The glass layer 14 is formed by conducting baking using glass frit with a grain size of greater than or equal to 1 µm and less than or equal to 10 µm, more preferably, greater than or equal to 1 µm and less than or equal to 5 µm. The glass layer 14 is formed under the following conditions: a baking temperature of greater than or equal to 430 °C and less than 580 °C, more preferably, greater than or equal to 480 °C and less than or equal to 520 °C and a baking time of greater than or equal to 5 minutes and less than or equal to 30 minutes, more preferably, greater than or equal to 10 minutes and less than or equal to 20 minutes. If the baking temperature is less than 430 °C, the glass will not melt sufficiently, while if the baking temperature is greater than or equal to 580 °C, crystallization of the bismuth-based glass cannot be suppressed, and the surface roughness (Ra) thus becomes coarse. The surface roughness (Ra) after the formation of the glass layer is preferably less than or equal to 10 nm. If the surface roughness (Ra) is over 10 nm, there is a possibility that electrical short may occur when a flexible device is completed.

The substrate 11 for flexible devices with the aforementioned structure can make the device more lighter compared to a glass substrate that has been conventionally used.

The substrate 11 for flexible devices can be used as a substrate for organic EL, for example, organic EL illumination, an organic EL display, or an organic solar battery.

Fig. 2 is a schematic diagram showing the cross-sectional structure of a substrate for organic EL illumination that uses the substrate 11 for flexible devices in accordance with this embodiment.

A substrate 21 for organic EL illumination has a structure in which an electrode layer (Ag, Al) 22, an organic thin-film light emitting layer 23, a transparent electrode layer 24, a transparent sealing layer 25, and a transparent sealing material 26 are laminated over the glass layer 14 that is an insulating film of the substrate 11 for flexible devices. A corrosion-resistant layer 27 is laminated below the metal base 12 of the substrate 11 for flexible devices.

According to the substrate 11 for flexible devices with the aforementioned structure, a Ni plating layer is formed over the surface of a metal base, and a glass layer is formed over the surface of the Ni plating layer. Thus, it is possible to obtain a light-weight, flexible metal substrate for flexible devices that has an excellent moisture barrier property and has formed glass with an excellent adhesion property to the metal base. Further, as electrically insulating bismuth-based glass is formed, the substrate also has an excellent insulating property and planarity, and thus can be used as a substrate for organic EL.

An organic polymeric material, such as an organic polymer, has a network structure and thus cannot essentially avoid permeation of moisture vapor therethrough. In contrast, an inorganic material, such as glass, has a dense structure and thus can completely avoid permeation of moisture therethrough, unlike an organic material. Thus, the substrate 11 for flexible devices has an excellent moisture barrier property.

In order to obtain a favorable adhesion state between a metal base and glass, it is necessary that a component that has been oxidized on the surface of the metal base react with an element in the glass components. With respect to the substrate 11 for flexible devices, when bismuth-based glass of the glass layer 14 reacts with an oxide generated on the surface of the Ni plating layer, an adhesion layer is formed. Thus, a favorable adhesion state can be obtained.

### [Examples]

### [Experiment 1]

An experiment to evaluate the adhesion property immediately after a glass layer of a substrate for flexible devices is formed was conducted.

### 1. Metal Base

### (1) Samples 1 and 2 (Ni-plated steel plate)

As a base, a steel plate, which has been obtained by conducting annealing/degreasing of a cold rolled plate of common steel (with a thickness of 0.35 mm) with the following chemical composition, was prepared.

Composition: 0.03 weight% C, 0.01 weight% Si, 0.25 weight% Mn, 0.008 weight% P, 0.005 weight% S, 0.051 weight% Al, and rest: Fe and inevitable components.

Then, after the prepared steel plate (size: a height of 12 cm, a width of 10 cm, a thickness of 0.32 mm, and a surface roughness (Ra) of 0.24 µm) was subjected to alkaline electrolytic degreasing and acid cleaning through sulfuric acid immersion, Ni plating was conducted under the following conditions, whereby a Ni plating layer with a thickness of 2 µm and a surface roughness of 0.24 µm was formed on each surface of the plate.

Bath composition: 300g/L nickel sulfate, 40g/L nickel chloride, 35g/L boric acid, and 0.4 mL/L pit inhibitor (sodium lauryl sulfate)
pH: 4 to 4.6
Bath temperature: 55 to 60 °C
Current density: 25 A/dm²

### (2) Samples 3 to 5 (Ni-plated steel plate + thermal treatment)

As a base, a cold rolled plate (with a thickness of 0. 12 mm), which has been obtained by repeatedly applying cold rolling and annealing to common steel with the following chemical composition, was prepared.

Composition: 0.02 weight% C, 0.01 weight% Si, 0.42 weight% Mn, 0.006 weight% P, 0.007 weight% S, 0.053 weight% Al, and rest: Fe and inevitable components.

Then, after the prepared steel plate (size: a height of 12 cm, a width of 10 cm, a thickness of 0.12 mm, and a surface roughness (Ra) of 0.10 µm) was subjected to alkaline electrolytic degreasing and acid cleaning through sulfuric acid immersion, Ni plating was conducted under the following conditions, whereby a Ni plating layer with a thickness of 2 µm and a surface roughness of 0.10 µm was formed on each surface of the base.

Bath composition: 300g/L nickel sulfate, 40g/L nickel chloride, 35g/L boric acid, and 0.4 mL/L pit inhibitor (sodium lauryl sulfate)
pH: 4 to 4.6
Bath temperature: 55 to 60 °C
Current density: 25 A/dm²

Next, the steel plate with the Ni plating layer formed thereon was subjected to thermal treatment in a reducing atmosphere at a temperature of 800 °C for 0.2 minutes to apply thermal diffusion treatment to the Ni plating layer, whereby a surface treated base, which has a Fe-Ni alloy layer between the surface of the metal base 12 and the Ni plating layer 13, was obtained.

### (3) Sample 6 (Comparative example: Cr-plated steel plate)

As a base, a steel plate, which has been obtained by applying annealing and temper rolling to a cold rolled plate of common steel (with a thickness of 0.32 mm) with the following chemical composition, was prepared.

Composition: 0.05 weight% C, 0.01 weight% Si, 0.33 weight% Mn, 0.010 weight% P, 0.009 weight% S, 0.054 weight% Al, and rest: Fe and inevitable components.

Then, after the prepared steel plate (size: a height of 12 cm, a width of 10 cm, a thickness of 0.32 mm, and a surface roughness of 0.24 µm) was subjected to alkaline electrolytic degreasing and acid cleaning through sulfuric acid immersion, chromium plating was conducted under the following conditions, whereby a chromium plating layer with a thickness of 20 nm and a surface roughness (Ra) of 0.24 µm was formed on each surface of the base.

Bath composition: 30 to 200g/L chromic acid and 1.5 to 10 g/L sodium fluoride
pH: less than or equal to 1
Bath temperature: 30 to 60 °C
Current density: 10 to 80 A/dm²

### (4) Sample 7 (Comparative example: non-plated steel plate)

As a base, a cold rolled plate (with a thickness of 0.30 mm), which has been obtained by repeatedly applying cold rolling and annealing to common steel with the following chemical composition, was prepared.

Composition: 0.05 weigh% C, 0.01 weight% Si, 0.30 weight% Mn, 0.012 weight% P, 0.011 weight% S, 0.048 weight% Al, and rest: Fe and inevitable components.
Size: height: 12 cm, width: 10 cm, thickness: 0.30 mm
Surface roughness (Ra): 0.22 µm

### 2. Formation of Glass Layer

Degreasing step: The surface of each of Samples 1 to 7 was wiped with gauze that has been immersed in alcohol, so as to be degreased.

Step of forming a coating film: A binder solution containing a mixture of an organic solvent and a binder was prepared, and the binder solution and glass frit with a softening temperature of 405 °C were mixed in a mortar to attain a weight ratio of 25:75, and then, the mixture was subjected to dispersion treatment using a ceramic roll to create a glass paste for forming a coating film. For the glass frit, bismuth-based glass that contains greater than or equal to 70 wt% Bi₂O₃ as a main component was used. Then, the glass paste was applied to a single side of the metal base using a bar coater so that a thickness of 20 µm is attained after baking. Thus, a coating film was formed.

Baking step: drying (temperature: 110 °C, time: 20 minutes), debinding (temperature: 330 °C, time: 20 minutes), and baking (temperature: 430 to 580 °C, time: 10 to 20 minutes) were conducted using a programmable electric furnace.

### 3. Evaluation Results

Table 1 shows the type of the plating treatment, baking temperature (°C), baking time (minutes), and adhesion property after the baking of each of Samples 1 to 7. The adhesion property of the glass layer was evaluated through visual observation. The surface property was also evaluated through visual observation.

**[Table 1]**

| Sample | | Substrate | Baking Temperature (°C) | Baking Time (Minutes) | Adhesion after Baking | Surface Property |
|---|---|---|---|---|---|---|
| 1 | Example | Ni-Plated | 430 | 20 | Good | Partially Matte |
| 2 | Example | Ni-Plated | 480 | 20 | Good | Glossy |
| 3 | Example | Ni-Plated + Thermal Treatment | 480 | 20 | Good | Glossy |
| 4 | Example | Ni-Plated + Thermal Treatment | 500 | 10 | Good | Glossy |
| 5 | Example | Ni-Plated + Thermal Treatment | 520 | 10 | Good | Glossy |
| 6 | Comparative Example | Cr-Plated | 480 | 20 | Glass Peeled Immediately after Baking | Glass Peeled Immediately after Baking |
| 7 | Comparative Example | Steel Plate (Non-Plated) | 480 | 20 | Good | Many Pinholes Generated |

With respect to Sample 6, the glass peeled immediately after the baking as the adhesion force was low. This is considered to be due to the reason that Cr that is deposited by plating is easily oxidized, a chromium oxide layer is thus formed on the surface, which in turn suppresses reactions between the bismuth-based glass and the metal.

Meanwhile, with respect to each of Samples 1 to 5 and 7, the adhesion property of the glass layer after the baking was found to be good. This is considered to be due to the reason that although both the steel plate and the Ni plating layer were oxidized to form an oxide layer, the chromium oxide layer and the oxide layer of iron and Ni differ in the thickness of the oxide layer as well as reaction behaviors, such as oxidation-reduction that occurs between the oxide layer and the glass, and thus that such a difference produced a difference in the adhesion property to the bismuth-based glass.

With respect to Sample 7, many pinholes were generated. This is considered to be due to the reason that gas was generated upon reaction between the oxide layer of iron and the bismuth-based glass. Further, when a flexible device is completed, rust would be generated on the surface on which glass is not formed. Thus, Sample 7 is not suitable for use as a substrate for flexible devices.

When the surface properties were evaluated through visual observation, Sample 1 was found to contain matte-like gloss defective portions that result from a failure of welding of the glass, though such defects are within the acceptable range.

### [Experiment 2]

With respect to each of Samples 3 to 5 that exhibited an excellent adhesion property and surface property after baking of the glass, evaluation of the surface roughness (Ra) and the wrapping adhesion property of the substrate for flexible devices was conducted as the evaluation of the smoothness. As the method for evaluating the wrapping adhesion property, the substrate for flexible devices was wrapped around a round bar with each diameter so as to cause tensile stress to act upon the glass layer, and then, the presence or absence of cracks and peeling were checked through visual observation.

### 1. Measurement of Surface Roughness of Glass Layer after Baking

After the step of baking the glass layer, the surface roughness (Ra) was measured on the SPM measurement mode of a microscope (i.e., nano search microscope, product number: OLS3500, produced by OLYMPUS CORPORATION).

(1) Sample 3
   The surface roughness (Ra) of the glass was 8.3 nm.
(2) Sample 4
   The surface roughness (Ra) of the glass was 1.7 nm.
(3) Sample 5
   The surface roughness (Ra) of the glass was 0.8 nm.

### 2. Evaluation Results

The created substrates for flexible devices were wrapped around iron round bars with diameters (φ) of 50 mm, 60 mm, 70 mm, 90 mm, and 120 mm, and the presence or absence of the generation of peeling were visually observed. Table 2 shows the results thereof.

**[Table 2]**

| Diameter (φ) | Sample 3 | Sample 4 | Sample 5 |
|---|---|---|---|
| 50 mm | × | × | × |
| 60 mm | × | × | × |
| 70 mm | × | ○ to Δ | ○ |
| 90 mm | ○ | ○ | ○ |
| 120 mm | ○ | ○ | ○ |

Presence or absence of peeling and cracks in the wrapping tests (visual observation)
○: No peeling at the glass/substrate interface was observed and no cracks were observed.
Δ: No peeling at the glass/substrate interface was observed but cracks were observed (very small degree).
×: No peeling at the glass/substrate interface was observed but cracks were observed (small degree).

With respect to Samples 3 to 5, no peeling was generated at the substrate interface between the Ni plating layer 13 and the glass layer 14 in the wrapping tests. However, a small degree of cracks was generated when round bars with diameters of up to 60 mm were used. With respect to Samples 3 and 4, a small degree of cracks or a very small degree of cracks was generated when round bars with diameters of up to 70 mm were used. Meanwhile, when round bars with diameters of 90 mm and 120 mm were used, no generation of peeling or cracks was confirmed.

The results of the present tests show that no peeling would occur even when the substrate of the present invention is injected into a roll-to-roll step, and clarify that the smoothness and the adhesion property that can be used for a substrate for flexible devices are obtained.

### Reference Signs List

- 11: Substrate for flexible devices
- 12: Metal base
- 13: Ni plating layer
- 14: Glass layer
- 21: Substrate for organic EL illumination

## Claims

1. A substrate for flexible devices, comprising:
a metal base;
a Ni plating layer formed over a surface of the metal base; and
a glass layer formed over a surface of the Ni plating layer by forming bismuth-based glass with an electrically insulating property in a form of a layer.

2. The substrate for flexible devices according to claim 1, having an adhesion layer between the Ni plating layer and the bismuth-based glass layer.

3. The substrate for flexible devices according to claim 1 or 2, further comprising an alloy layer formed by thermal treatment between the metal base and the Ni plating layer.

4. The substrate for flexible devices according to any one of claims 1 to 3, wherein the glass layer has a softening point of greater than or equal to 330 °C and less than or equal to 450 °C.

5. A method for producing a substrate for flexible devices, comprising:
a plating step of forming a Ni plating layer over a surface of a metal base; and
a glass layer forming step of forming a glass layer of bismuth-based glass with an electrically insulating property over a surface of the Ni plating layer.

6. The method for producing a substrate for flexible devices according to claim 5, wherein the plating step includes applying thermal treatment after forming the Ni plating layer, thereby forming an alloy layer between the metal base and the Ni plating layer.

7. The method for producing a substrate for flexible devices according to claim 5 or 6, wherein the glass layer forming step includes forming a glass layer having an electrically insulating property over the surface of the Ni plating layer by baking a bismuth-based glass frit.

8. The method for producing a substrate for flexible devices according to any one of claims 5 to 7, wherein the glass layer forming step includes baking glass frit at a baking temperature of greater than or equal to 430 °C and less than 580 °C for a baking time of greater than or equal to 5 minutes and less than or equal to 30 minutes.

9. A substrate for organic EL illumination, comprising:
the substrate for flexible devices according to any one of claims 1 to 4,
an electrode layer formed over the glass layer of the substrate for flexible devices;
an organic thin-film light emitting layer formed over the electrode layer; and
a transparent electrode layer formed over the organic thin-film light emitting layer.

## Patentansprüche

1. Substrat für biegsame Vorrichtungen, umfassend:
ein Metallträgermaterial;
eine Ni-Plattierungsschicht, die über einer Oberfläche des Metallträgermaterials gebildet ist; und
eine Glasschicht, die über einer Oberfläche der Ni-Plattierungsschicht dadurch gebildet ist, dass ein Glas auf Wismutgrundlage mit einer elektrisch isolierenden Eigenschaft in Form einer Schicht gebildet ist.

2. Substrat für biegsame Vorrichtungen nach Anspruch 1, das zwischen der Ni-Plattierungsschicht und der Glasschicht auf Wismutgrundlage eine Haftschicht aufweist.

3. Substrat für biegsame Vorrichtungen nach Anspruch 1 oder 2, das ferner eine Legierungsschicht umfasst, die durch Wärmebehandlung zwischen dem Metallträgermaterial und der Ni-Plattierungsschicht gebildet ist.

4. Substrat für biegsame Vorrichtungen nach einem der Ansprüche 1 bis 3, wobei die Glasschicht einen Erweichungspunkt von größer oder gleich 330 °C und kleiner oder gleich 450 °C aufweist.

5. Verfahren zum Herstellen eines Substrats für biegsame Vorrichtungen, wobei das Verfahren umfasst:
einen Plattierungsschritt zum Bilden einer Ni-Plattierungsschicht über einer Oberfläche eines Metallträgermaterials; und
einen Glasschichtbildungsschritt zum Bilden einer Glasschicht aus einem Glas auf Wismutgrundlage mit einer elektrisch isolierenden Eigenschaft über einer Oberfläche der Ni-Plattierungsschicht.

6. Verfahren zum Herstellen eines Substrats für biegsame Vorrichtungen nach Anspruch 5, wobei der Plattierungsschritt das Anwenden einer Wärmebehandlung nach dem Bilden der Ni-Plattierungsschicht umfasst, wodurch eine Legierungsschicht zwischen dem Metallträgermaterial und der Ni-Plattierungsschicht gebildet wird.

7. Verfahren zum Herstellen eines Substrats für biegsame Vorrichtungen nach Anspruch 5 oder 6, wobei der Glasschichtbildungsschritt das Bilden einer Glasschicht, die eine elektrisch isolierende Eigenschaft aufweist, über der Oberfläche der Ni-Plattierungsschicht durch Brennen einer Glasfritte auf Wismutgrundlage umfasst.

8. Verfahren zum Herstellen eines Substrats für biegsame Vorrichtungen nach einem der Ansprüche 5 bis 7, wobei der Glasschichtbildungsschritt das Brennen der Glasfritte bei einer Brenntemperatur von größer oder gleich 430 °C und kleiner 580 °C während einer Brennzeit von größer oder gleich 5 Minuten und kleiner oder gleich 30 Minuten umfasst.

9. Substrat für eine organische EL-Beleuchtung, umfassend:
das Substrat für biegsame Vorrichtungen nach einem der Ansprüche 1 bis 4,
eine Elektrodenschicht, die über der Glasschicht des Substrats für biegsame Vorrichtungen gebildet ist;
eine Lichtemitterschicht eines organischen Dünnfilms, die über der Elektrodenschicht gebildet ist; und
eine lichtdurchlässige Elektrodenschicht, die über der Lichtemitterschicht des organischen Dünnfilms gebildet ist.

## Revendications

1. Substrat pour dispositifs flexibles comprenant :
une base métallique ;
une couche de placage en Ni formée sur une surface de la base métallique ; et
une couche de verre formée sur une surface de la couche de placage en Ni en formant du verre à base de bismuth avec une propriété électriquement isolante sous la forme d'une couche.

2. Substrat pour dispositifs flexibles selon la revendication 1, ayant une couche d'adhésion entre la couche de placage en Ni et la couche de verre à base de bismuth.

3. Substrat pour dispositifs flexibles selon la revendication 1 ou 2, comprenant en outre une couche d'alliage formée par traitement thermique entre la base métallique et la couche de placage en Ni.

4. Substrat pour dispositifs flexibles selon l'une quelconque des revendications 1 à 3, dans lequel la couche de verre a un point de ramollissement supérieur ou égal à 330°C et inférieur ou égal à 450°C.

5. Procédé de production d'un substrat pour dispositifs flexibles comprenant :
une étape de placage consistant à former une couche de placage en Ni sur une surface d'une base métallique ; et
une étape de formation de couche de verre consistant à former une couche de verre à base de bismuth avec une propriété électriquement isolante sur une surface de la couche de placage en Ni.

6. Procédé de production d'un substrat pour dispositifs flexibles selon la revendication 5, dans lequel l'étape de placage inclut appliquer un traitement thermique après la formation de la couche de placage en Ni, formant de ce fait une couche d'alliage entre la base métallique et la couche de placage en Ni.

7. Procédé de production d'un substrat pour dispositifs flexibles selon la revendication 5 ou 6, dans lequel l'étape de formation de couche de verre inclut former une couche de verre ayant une propriété électriquement isolante sur la surface de la couche de placage en Ni en cuisant une fritte de verre à base de bismuth.

8. Procédé de production d'un substrat pour dispositifs flexibles selon l'une quelconque des revendications 5 à 7, dans lequel l'étape de formation de couche de verre inclut cuire une fritte de verre à une température de cuisson supérieure ou égale à 430°C et inférieure à 580°C pendant une durée de cuisson supérieure ou égale à 5 minutes et inférieure ou égale à 30 minutes.

9. Substrat pour éclairement électroluminescent organique comprenant :
le substrat pour dispositifs flexibles selon l'une quelconque des revendications 1 à 4,
une couche d'électrode formée sur la couche de verre du substrat pour dispositifs flexibles ;
une couche d'émission lumineuse à film fin organique formée sur la couche d'électrode ; et
une couche d'électrode transparente formée sur la couche d'émission lumineuse à film fin organique.
